# EUROPEAN PATENT APPLICATION

(11) **EP 2 173 091 A1**
(43) Date of publication of application: **07.04.2010**
(21) Application number: 08777996.3
(22) Date of filing: 09.07.2008
(51) Int. Cl.: H04N 5/335, G02B 3/00, G02B 7/02, H01L 27/14, H04N 5/225

(54) **METHOD FOR MANUFACTURING IMAGING DEVICE, IMAGING DEVICE AND PORTABLE TERMINAL**

(30) Priority: 02.08.2007 JP 2007201759
(71) Applicant: Konica Minolta Opto, Inc., Hachioji-shi, Tokyo 192-8505 (JP)
(72) Inventor: SAITO, Masashi, Hachioji-shi Tokyo 192-8505 (JP)
(74) Representative: Henkel, Feiler & Hänzel
(86) International application number: PCT/JP2008/062387
(87) International publication number: WO 2009/016931

(57) **Abstract**

Provided are a manufacturing method for obtaining a low-cost imaging device, and the low-cost imaging device manufactured by such method. The method for manufacturing the imaging device is provided with a step of integrally forming a plurality of imaging devices by using a plurality of imaging optical systems for guiding photographing object light and a plurality of imaging elements for photoelectrically converting the photographing object light, and a step of dividing the integrally formed imaging devices by cutting into individual imaging devices. In the step of integrally forming the imaging devices, a shape for positioning the integrally formed imaging devices is formed.

## Description

### TECHNICAL FIELD

The present invention relates to a manufacturing method for an imaging device having therein an imaging optical system that guides light of a photographic object and an imaging element that converts light of a photographic object guided by the imaging optical system photoelectrically, then, to an imaging device and to a mobile terminal equipped with the imaging device.

### BACKGROUND OF THE INVENTION

An imaging device that is smaller and thinner than a conventional imaging device has come to be equipped on a mobile terminal representing a small-sized and thin electronic instrument such as a mobile phone and PDA (Personal Digital Assistant), and it has become possible to transmit not only voice information but also image information mutually between remote places.

As a manufacturing method of the small-sized imaging device of this kind, there is known an object which is obtained by cementing a lens array in which a plurality of optical lenses are formed on a silicone wafer on which plural imaging elements are formed in a shape of an array, and by dividing the lens array depending on arrangement of the imaging elements (for example, see Patent Document 1).
Patent Document 1: Unexamined Japanese Patent Application Publication No. 2002-290842.

### DISCLOSURE OF THE INVENTION

### PROBLEMS TO BE SOLVED BY THE INVENTION

However, in the manufacturing method in the aforesaid Patent Document 1, plural lens array corresponding to plural imaging elements on the silicone wafer are cemented and then are cut to be separated. Thus, a lens is arranged unavoidably also on a defective imaging element having some sort of a fault, and the lens has no option but to be scrapped together with the defective imaging element, resulting in a problem of a cost increase.

In addition, a final inspection for each imaging device has no option but to be made after cutting and separating, thus, a man-hour is increased and an efficiency is low, resulting equally in a problem of a cost increase.

The present invention is one achieved in view of the aforesaid problems, and its objective is to acquire a manufacturing method that can obtain a low cost imaging device and to offer the low cost imaging device by the manufacturing method.

### MEANS TO SOLVE THE PROBLEMS

The aforesaid objects are attained by the embodiments described below.

Item 1: A manufacturing method for an imaging device having therein a process to form plural imaging devices integrally by using plural imaging optical systems each guiding light of photographic object and plural imaging elements each converting light of photographic object photoelectrically, and a process to cut plural imaging devices formed integrally to separate into each imaging device, wherein, in the process to form plural imaging devices to be one body, there is formed a shape for positioning plural imaging devices formed to be one body.

Item 2: The manufacturing method for an imaging device according to Item 1, wherein there are inserted processes each inspecting each imaging device in the state where the devices are formed to be one body, between the process to form plural imaging devices to be one body and the process to cut plural imaging devices formed to be one body to separate them into each imaging device.

Item 3: The manufacturing method for an imaging device according to Item 1 or Item 2, wherein there are provided, before the aforesaid process to form plural imaging devices to be one body, the processes including a process to form the aforesaid plural imaging elements on a surface of one side of the silicone wafer, an inspection process to inspect the aforesaid imaging elements, a process to enclose only imaging elements judged to be non-defective in the aforesaid inspection process with a light-transmitting member for each imaging element, a process to cut the aforesaid silicone wafer for each of the aforesaid imaging elements, a process to place the aforesaid plural imaging elements which have been cut on a substrate, a process to connect the substrate electrically to the plural imaging elements and a process to arrange the aforesaid imaging optical system on the aforesaid light-transmitting member.

Item 4: The manufacturing method for an imaging device according to any one of Items 1 -3, wherein the aforesaid imaging optical system is manufactured by a process to laminate a diaphragm plate member on which plural diaphragm shapes are formed, a lens member on which plural lens sections are formed and a spacer member on which plural spacer sections for adjusting a space from the aforesaid imaging element and by a process to cut the aforesaid laminated diaphragm plate member, the lens member and the spacer member.

Item 5: An imaging device **characterized in that** the imaging device is manufactured by any one of the manufacturing methods for an imaging device of Items 1 -4.

Item 6: A mobile terminal **characterized in that** the imaging device is equipped with the imaging device described in Item 5.

### EFFECT OF THE INVENTION

In the present embodiment, it is possible to obtain a manufacturing method that makes it possible to acquire a low-cost imaging device, and this manufacturing method makes it possible to offer the low-cost imaging device.

### BRIEF DESCRIPTION OF THE DRAWINGS

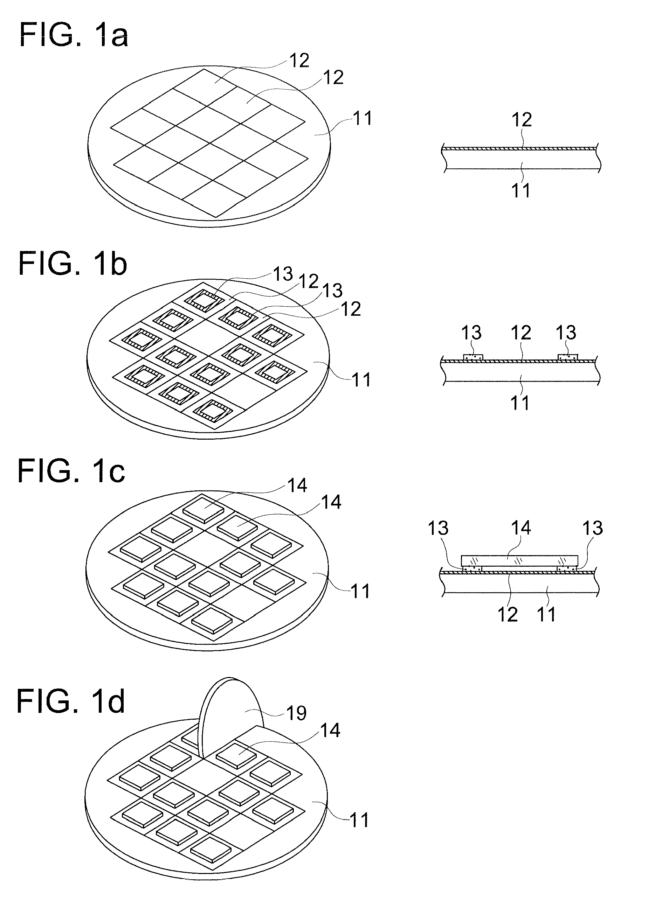

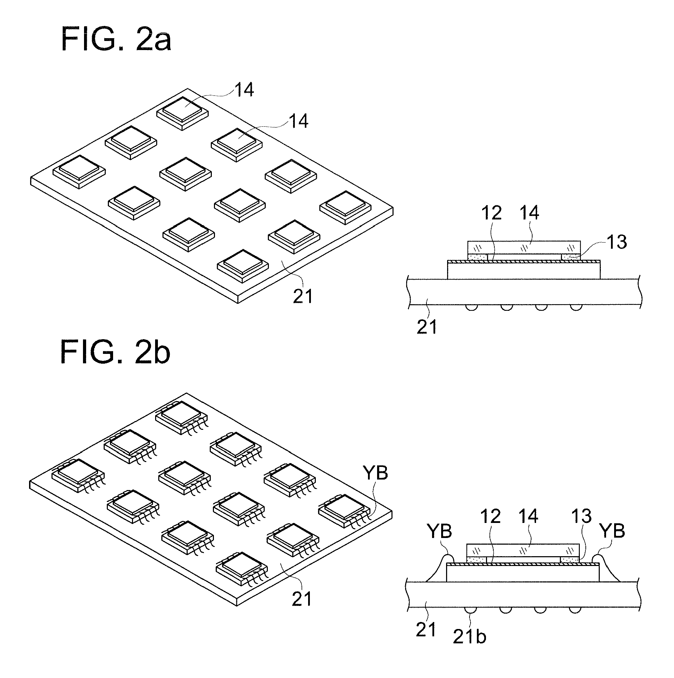

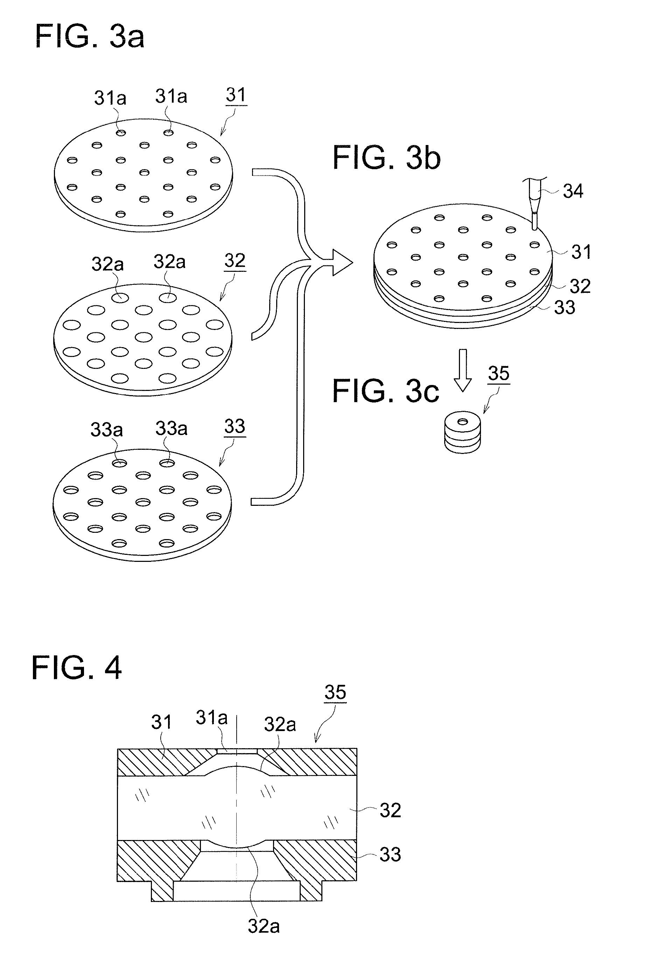

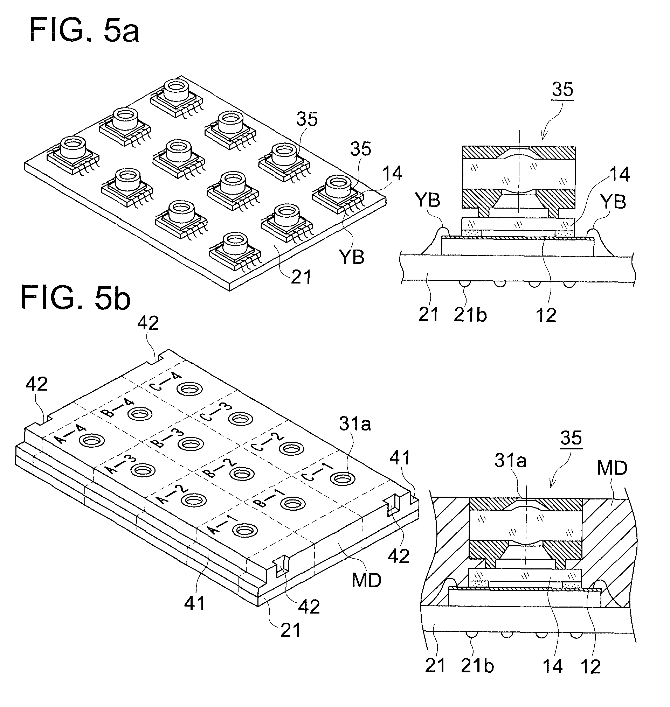

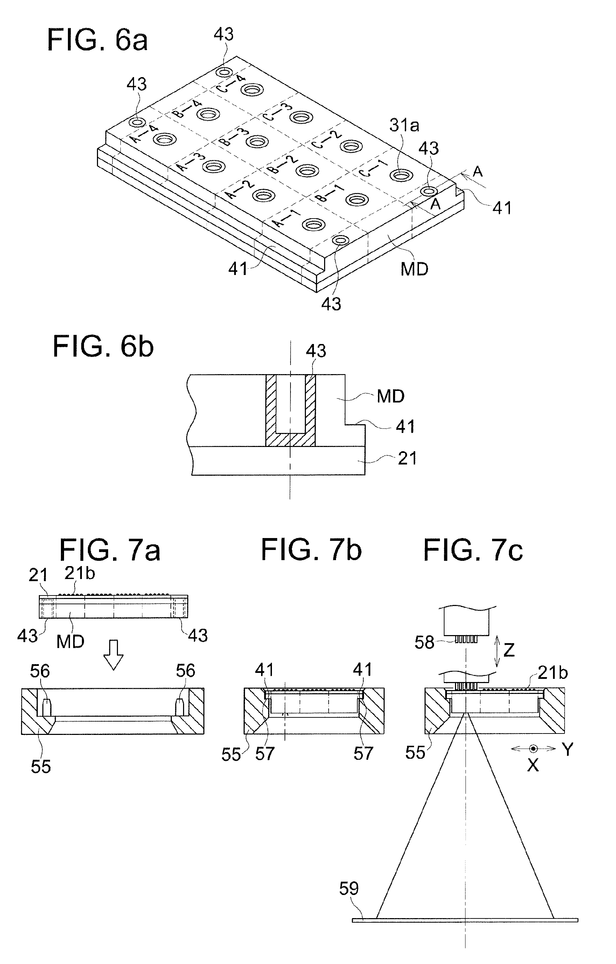

Each of Figs. 1a to 1d is a pattern diagram showing an initial process stage of a manufacturing method for an imaging device relating to the present embodiment of the invention.
Each of Figs. 2a and 2b is a pattern diagram showing a process stage following the process shown in Fig. 1 of a manufacturing method for an imaging device relating to the present embodiment of the invention.
Each of Figs. 3a to 3c is a diagram showing an assembling process for an imaging optical system unit in manufacturing methods for an imaging device relating to the present embodiment of the invention.
Fig. 4 is a sectional view of an imaging optical system unit formed by a process shown in each of Figs. 3a to 3c.
Each of Figs. 5a and 5b is a pattern diagram showing a late-term process stage of a manufacturing method for an imaging device relating to the present embodiment of the invention.
Each of Figs. 6a and 6b is a diagram showing another example of a form for positioning that is formed in the process shown in Fig. 5b.
Each of Figs. 7a to 7c is a pattern diagram showing an inspection process for plural imaging devices formed to be one body.
Fig. 8 is a sectional view of a finished article for an imaging device relating to the present embodiment of the invention.
Fig. 9 is a sectional view showing another example for an imaging device relating to the present embodiment of the invention.
Fig. 10 is an appearance diagram of a mobile phone that is an example of a mobile terminal equipped with the imaging device relating to the present embodiment of the invention.
Fig. 11 is a control block diagram for the mobile phone.

### EXPLANATION OF SYMBOLS

- 11: Silicone wafer
- 12: Imaging element
- 13: Adhesive agent
- 14: Light-transmitting member
- 19: Dicing blade
- 21: Substrate
- 31: Diaphragm plate member
- 32: Lens member
- 33: Space member
- 35: Imaging optical system unit
- 41: Step portion
- 42: Recessed portion
- 50: Imaging device
- 100: Mobile phone
- MD: Resin material
- YB: Bonding wire

### PREFERRED EMBODIMENT FOR PRACTICING THE INVENTION

The invention will be explained in detail as follows, referring to the embodiment, to which, however, the invention is not limited.

Each of Figs. 1a to 1d is a pattern diagram showing an initial process stage of a manufacturing method for an imaging device relating to the present embodiment of the invention. A row on the left side in the diagram shows the state of an outline of the whole, and a row on the right side is a sectional view showing the rough state of one piece.

First, a plurality of imaging elements 12 are formed on a surface on one side of silicone wafer 11 shown in Fig. 1a. This process is a process to form plural imaging elements 12 in a form of an array by repeating a widely-known casting process, a photo-lithography process, an etching process, and an impurity adding process and by forming a transmission electrode, an insulating membrane and a wired pattern to be in a multistructure. This imaging element 12 is an imaging element such as, for example, a CCD (Charge Coupled Device) type imaging element or a CMOS (Complementary Metal-Oxide Semiconductor) type imaging element.

After this, the imaging elements 12 thus formed are inspected respectively to be divided into non-defectives and defectives. This is to separate defectives and non-defectives formed in the manufacture process for forming plural imaging elements 12 on the surface of the aforesaid silicone wafer 11. Inspection items include, for example, presence or absence of lacks of wiring pattern, whether a width of a wiring pattern line and a width of a pitch are a prescribed length or not, presence or absence of scratches, soils and cracks on a sensor itself, and sticking of foreign materials on the sensor surface. This inspection is carried out by using a widely-known semiconductor inspection instrument, and an imaging element on which no abnormality is observed is judged to be a non-defective, and an imaging element on which abnormality is observed is judged to be a defective, to be separated.

Then, adhesive agents 13 are coated only on those judged to be non-defectives of the plural imaging elements 12 formed on the silicone wafer 11, as shown in Fig. 1b. This adhesive agent 13 is coated on a position that is outside the area for light-receiving pixel of the imaging element 12, and by adjusting an amount of coating of the adhesive agent 13, a space between a light-transmitting member stuck on the upper portion of the area for light-receiving pixel of the imaging element 12 and a light-receiving pixel surface is determined.

After this, as shown in Fig. 1c, light-transmitting member 14 is stuck. Owing to adhesion of this light-transmitting member 14, the light-receiving pixel area of the imaging element 12 is sealed. A surface side of this light-transmitting member 14 undergoes infrared blocking coating.

Then, as shown in Fig. 1d, silicone wafer 11 is cut by dicing blade 19 into each imaging element. This creates a chip of each imaging element 12 in which a light-receiving pixel area is sealed by light-transmitting member 14.

Each of Figs. 2a and 2b is a pattern diagram showing a succeeding process stage for the processes shown in Figs. 1a to 1d of the manufacturing methods of imaging devices relating to the present embodiment. In the following diagrams, explanations are given by giving same symbols to same members to avoid repetition of examples.

Chips of respective imaging elements 12 each having thereon light-transmitting member 14 formed and stuck as stated above are placed on substrate 21 as shown by Fig. 2a. The substrate 21 is one on which plural wiring patterns for respective imaging elements 12 are formed, so that chips for plural imaging elements 12 may be placed.

Namely, with respect to chips of respective imaging elements 12 to be placed in this case, the chips which have been judged to be non-defectives only are placed. This prevents that lenses to be incorporated thereafter are wasted.

Then, as shown in Fig. 2b, a chip of imaging element 12 is connected with substrate 21 electrically by bonding wire YB. On the other surface of the substrate 21, there are formed plural external electrodes 21b (for example, soldering poles) used for connection with unillustrated other control substrates. Owing to this, input and output of signals between an unillustrated another control substrate connected to substrate 21 and imaging element 12 is made to be possible.

Each of Figs. 3a to 3c is a diagram showing an assembling process for an imaging optical system unit, among manufacturing methods relating to the present embodiment.

As shown in Fig. 3a, there are formed diaphragm plate member 31 on which plural diaphragms 31a are formed, lens member 32 on which plural lens sections 32a are formed and spacer member 33 on which plural apertures 33a are formed. Incidentally, each of diaphragm plate member31 and spacer member 33 is formed by light-shielding material.

Next, as shown in Fig. 3b, the diaphragm plate member 31, the lens member 32 and the spacer member 33 are cemented together, to be superimposed, and the superimposed one is separated by end mill 34, for example, to become each imaging optical system unit as shown in Fig. 3c.

Fig. 4 is a sectional view of an imaging optical system unit that is formed by processes shown in Figs. 3a - 3c.

As shown in Fig. 4, diaphragm 31a of diaphragm plate member 31 and aperture section 33a of spacer member 33 cause lens section 32a of lens member 32 to be interposed between them to become imaging optical system unit 35. Incidentally, though an explanation is given under the condition of the imaging optical system in which a lens is a single lens in the present example, the imaging optical system may also be one wherein plural lenses are unitized simultaneously.

Each of Figs. 5a to 5b is a pattern diagram showing the late period process stage of a manufacturing method for an imaging device relating to the present embodiment of the invention.

As shown in Fig. 5a, imaging optical system unit 35 formed in the process shown in Fig. 4 is cemented tentatively on plural light-transmitting member 14 on substrate 21 formed in the process shown in Fig. 2b.

Then, as shown in Fig. 5b, light-shielding resin material (for example, resin) MD is used to form in a unified manner so that diaphragm 31a only may be exposed. Owing to this, plural (12 pieces in the illustration) imaging devices are formed integrally. When these imaging devices are formed integrally, illustrated recessed portion 42 and step portion 41 both for positioning used in the inspection process thereafter are formed by a die that is used for molding.

An inspection process for inspecting each imaging device in plural imaging devices formed integrally after the foregoing is provided. In this inspection process, each imaging device is caused to image charts by using the step portion 41 and the recessed portion 42 as positioning members for jigs for use in inspections, so that each imaging device may be inspected. In the inspection of the imaging device, a plurality of imaging devices can be inspected at a time, and the aforesaid step portion 41 and the recessed portion 42 provided for positioning make automatic inspections to be easy. Further, there are formed identification marks for identifying each imaging device as shown in Fig. 5b, therefore, it is possible to delete after cutting and separating based on results of the inspections.

Each of Figs. 6a and 6b is a diagram showing another example of a form for positioning formed in the process shown in Fig. 5b.

In Figs. 6a and 6b, forms for positioning used in the inspection process from this point forward for the plural imaging devices formed integrally have been made to be step portion 41 and a hole of sleeve-shaped members 43 at four locations shown in Fig. 6a.

Fig. 6b shows a section taken on line A - A shown in Fig. 6a. In the case of the present example, the sleeve-shaped member 43 is cemented on substrate 21 after positioning under the state shown in Fig. 5a, and after that, light-shielding resin material (for example, resin) MD is used to form imaging devices integrally so that diaphragm 31a and the hole of the sleeve-shaped member 43 may be exposed.
A shape for positioning used in the case of inspection processes may also be like this.

Each of Figs. 7a to 7c is a pattern diagram showing inspection processes for plural imaging devices formed integrally. The Figs. 7a to 7c show the occasion of inspecting plural imaging devices shown integrally in Figs. 6a and 6b.

As shown in Fig. 7a, columnar sections 56 are formed on carriage 55 at positions corresponding to holes of the sleeve-shaped members 43 on the integrated plural imaging devices. In this carriage 55, the integrated plural imaging devices are set with the holes of the sleeve-shaped members 43 and the columnar sections 56 both engaging with each other. Fig. 7b is a diagram showing a relationship between the carriage 55 and the step portion 41 that is formed on the integrated plural imaging devices. As is shown in Fig. 7b, step portion 57 formed on the carriage 55 and step portion 41 formed on the integrated plural imaging devices are arranged to make contact with each other.

Namely, the direction perpendicular to the optical axis of the imaging device is positioned by the sleeve-shaped member 43 and by the columnar sections 56, while, the optical axis direction is positioned by the step portions 41 and 57.

Then, as shown in Fig. 7c, connection pin 58 is caused to touch to be connected with plural external electrodes 21b used for connection with a control substrate for the integrated plural imaging devices which are set on the carriage 55, to drive the imaging devices to image inspection charts 59, so that an inspection for the imaging device may be made.

After the inspection for a single imaging device is terminated, the connection pin 58 is moved in the direction of arrow Z in the illustration to leave, then, after the carriage 55 is moved properly in the direction of arrow X and in the direction of arrow Y, the connection pin 58 is caused to touch to be connected to drive the following imaging device to image inspection charts 59 equally, so that the final inspection may be made. In the present example, positions of the connection pin 58 in the directions X and Y and positions of the inspection chart 59 in the directions X and Y are fixed.

The aforesaid operations are repeated to make the final performance inspection for each of the integrated plural imaging devices. Namely, final inspections for respective imaging devices formed integrally by setting once can be made automatically in a short period of time, without making inspections by replacing each imaging device. Owing to this, reduction of a man-hour and cost reduction become possible.

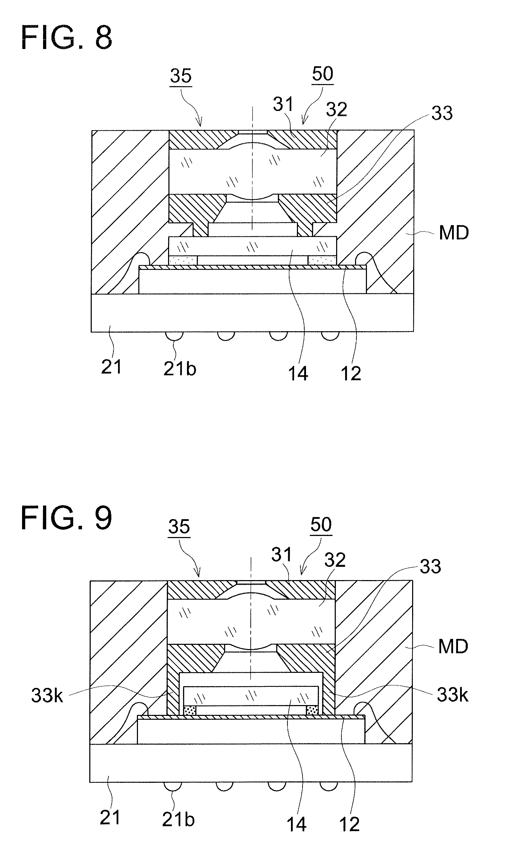

After termination of the inspections, step portions 41 shown in Fig. 5b and Fig. 6a on integrated plural imaging devices are cut, and the integrated plural imaging devices are cut and separated on broken lines, thus, imaging device 50 representing a single item shown in Fig. 8 is created, which means completion.

Fig. 9 is a sectional view showing another example for imaging device 50 relating to the present embodiment. With respect to the imaging device shown in Fig. 9, only points of the imaging device which are different from those shown in Fig. 8 will be explained.

Imaging device 50 shown in Fig. 9 is one which is different in terms of a shape of spacer 33 of imaging optical system unit 35 from the imaging device shown in Fig. 8. Namely, the imaging device 50 is one wherein leg portion 33k of spacer 33 of imaging optical system unit 35 comes in contact with imaging element 12. As shown in Fig. 9, light-transmitting member 14 is arranged inside the leg portion 33k.

Incidentally, in the aforesaid embodiment, an explanation has been given, referring to the example wherein 12 imaging devices were formed integrally, and then, were cut and separated. However, the number of imaging devices to be formed integrally is not naturally limited to 12.

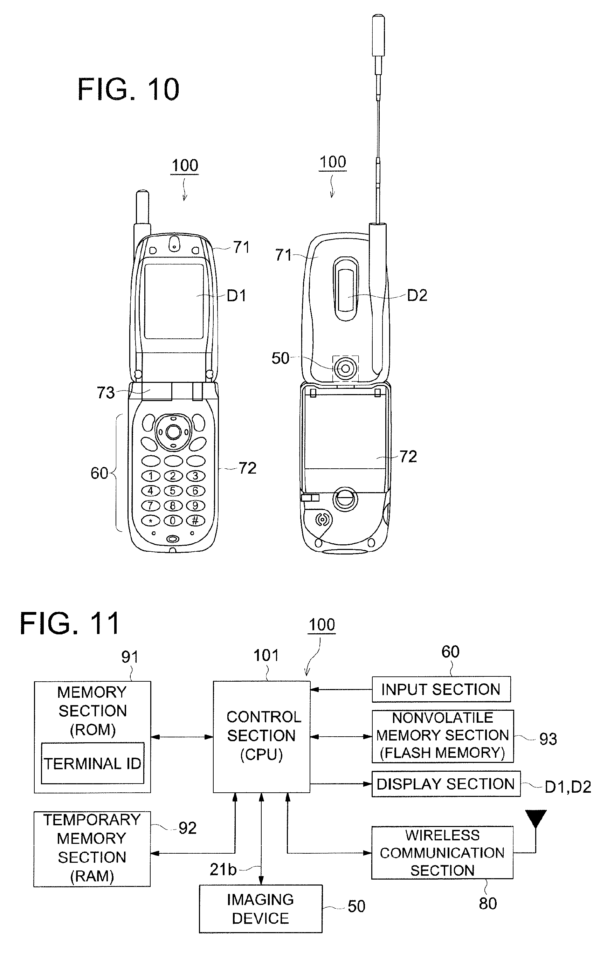

Fig. 10 is an appearance diagram of mobile phone 100 that is an example of a mobile terminal equipped with the imaging device 50 relating to the present embodiment.

With respect to mobile phone 100 shown in Fig. 10, upper casing 71 representing a case equipped with display screens D1 and D2 and lower casing 72 equipped with operation button 60 representing an input section are connected to each other through hinge 73. Imaging device 50 is housed at a lower portion of the display screen D2 in the upper casing 71, so that the imaging device 50 may take in light from the outer surface side of the upper casing 71.

Meanwhile, with respect to the position of the imaging device, it may also be arranged on the upper portion or on the side of the display screen D2 in the upper casing 71. Further, the mobile phone is not naturally limited to a folding type.

Fig. 11 is a control block diagram for mobile phone 100.

As is shown in Fig. 11, the imaging device 50 is connected, through its external electrode 21b, with control section 101 of the mobile phone 100, and the imaging device 50 outputs image signals such as luminance signals and color difference signals to the control section 101.

On the other hand, the mobile phone 100 is equipped with control section (CPU) 101 that controls respective portions collectively and practices programs corresponding to respective processes, operation button 60 that is an input section for indicating or inputting numbers, display screens D1 and D2 that display prescribed data and display images which have been taken, wireless communication section 80 for realizing various types of information communication with external servers, memory section (ROM) 91 in which necessary various types of data such as system programs of the mobile phone 100, various types of processing programs and terminal ID, are stored, and with temporary memory section (RAM) 92 that stores temporarily various types of processing programs practiced by control section 101 and data, or processing data and image data by imaging device 50, and is used as a working area.

Image signals inputted from the imaging device 50 are further arranged to be stored in nonvolatile memory section (flash memory) 93 by control section 101 of mobile phone 100, or to be displayed on display screens D1 and D2, and further, to be transmitted to an outside as image information through wireless communication 80.

## Claims

1. A manufacturing method for an imaging device comprising a process to form a plurality of imaging devices integrally by using plural imaging optical systems each guiding light of a photographic object and by using plural imaging elements each converting the light of a photographic object photoelectrically, and a process to cut plural imaging devices formed integrally to separate them into respective imaging devices, wherein a configuration for positioning plural imaging devices formed integrally is formed in the process to form the plural imaging devices integrally.

2. The manufacturing method for an imaging device according to the Claim 1, wherein there is provided a process to inspect each imaging device under the condition that imaging devices are formed integrally, between a process to form a plurality of imaging devices integrally and a process to cut said plural imaging devices formed integrally to separate them into each imaging device.

3. The manufacturing method for an imaging device according to the Claim 1 or 2, wherein there are provided, preceding the process to form plural imaging devices, a process to form the aforesaid plural imaging elements on a surface on one side of a silicone wafer, an inspection process to inspect the aforesaid imaging element, a process to seal only the imaging element judged to be non-defective in the aforesaid inspection process, with light-transmitting member for the aforesaid each imaging element, a process to cut the aforesaid silicone wafer into respective imaging elements, a process to place, on a substrate, the plural imaging elements thus cut, a process to connect the aforesaid substrate with aforesaid plural imaging elements electrically and a process to arrange the aforesaid imaging optical system on the light-transmitting member.

4. The manufacturing method for an imaging device according to any one of the Claims 1 to 3, wherein the aforesaid imaging optical system is manufactured by a process to laminate a diaphragm plate member on which plural diaphragm shapes are formed, a lens member on which plural lens sections are formed and a spacer member on which plural spacer sections for adjusting a space from the aforesaid imaging element and by a process to cut the aforesaid laminated diaphragm plate member, the lens member and the spacer member.

5. An imaging device **characterized in that** the imaging device is manufactured by the manufacturing method for an imaging device according to any one of the Claims 1 to 4.

6. A mobile terminal **characterized in that** the mobile terminal is equipped with the imaging device described in the Claim 5.
